# EUROPÄISCHE PATENTSCHRIFT

(11) **EP 3 347 243 B1**
(45) Veröffentlichungstag und Bekanntmachung des Hinweises auf die Patenterteilung: **21.08.2019**
(21) Anmeldenummer: 16785174.0
(22) Anmeldetag: 24.10.2016
(51) Int. Cl.: B60R 16/02, B60R 16/023, H05K 7/02, H05K 5/02, H02G 3/16, H01R 4/30, H01R 11/12, H01R 9/22, H01B 5/02

(54) **VORRICHTUNG ZUM VERBINDEN VON ELEKTRISCHEN BAUTEILEN MIT EINER STROMVERSORGUNG**
DEVICE FOR CONNECTING ELECTRICAL COMPONENTS WITH A POWER SUPPLY
DISPOSITIF POUR CONNECTER DES COMPOSANTS ÉLECTRIQUES À UNE ALIMENTATION ÉLECTRIQUE

(30) Priorität: 28.10.2015 DE 102015118443; 18.02.2016 DE 202016100869 U; 23.03.2016 DE 202016101623 U
(43) Veröffentlichungstag der Anmeldung: 18.07.2018
(73) Patentinhaber: Eugen Forschner GmbH, 78549 Spaichingen (DE)
(72) Erfinder: GROTZ, Michael, 78549 Spaichingen (DE); SAUTTER, Sven, 78549 Spaichingen (DE); MENEGHINI, Sebastian, 78549 Spaichingen (DE)
(74) Vertreter: Wiese, Gerhard
(86) Internationale Anmeldenummer: PCT/EP2016/075553
(87) Internationale Veröffentlichungsnummer: WO 2017/072073

(56) Entgegenhaltungen:
- EP-A1- 1 641 081
- EP-A1- 2 063 495
- EP-A1- 2 728 982
- EP-A2- 0 735 622
- DE-A1- 19 715 824
- DE-T5-112009 000 946
- DE-U1-202015 103 854
- JP-A- 2004 032 960
- JP-A- 2014 229 415
- JP-U- H0 220 368
- US-A- 4 781 621
- US-A1- 2002 043 882
- US-A1- 2013 292 156
- US-B1- 6 220 876

## Beschreibung

Die Erfindung betrifft eine Vorrichtung zum Verbinden von elektrischen Bauteilen mit einer Stromversorgung gemäß dem Oberbegriff des Patentanspruchs 1.

Typischerweise werden bislang Stromschienen aus gestanzten und gebogenen Blechen - wie beispielsweise aus der DE 197 15 824 A1 oder aus der DE 20 2015 103 854 U1 bekannt oder in Figur 4 dargestellt - oder Kontaktplatinen mit integrierten Leiterbahnen für die Verbindung mehrerer in einem Gehäuse angeordneter elektrischer Bauteile mit einer Stromversorgung verwendet. Bei einer komplexen dreidimensionalen Anordnung mehrerer elektrischer Bauteile stoßen diese Lösungen an ihre Grenzen, da eine einzige Stromschiene nur begrenzt verformbar ist und eine Platine selbst in einer mehrlagigen, abgewinkelten Ausführungsform Kontaktpunkte nur in zwei senkrecht zueinander stehenden Ebenen bereitstellen kann, wie dies beispielsweise aus der EP 2 728 982 A1 ersichtlich ist. Aus der US 2013/292156 A1 ist eine Vorrichtung bekannt, bei der eine Stromschiene in einer Variante abschnittsweise auch einen kreisförmigen Querschnitt aufweisen kann.

Aufgabe der Erfindung ist es, eine Vorrichtung zum Verbinden von elektrischen Bauteilen mit einer Stromversorgung bereit zu stellen, mittels der nahezu beliebig komplexe dreidimensionale Leitungswege erreichbar sind.

Diese Aufgabe wird durch eine Vorrichtung mit den Merkmalen des Anspruchs 1 gelöst. Vorteilhafte Ausgestaltungen der Erfindung sind in den Unteransprüchen angegeben.

Die erfindungsgemäße Vorrichtung wird im Wesentlichen aus wenigstens einem dreidimensional geformten Draht gebildet, in den zumindest an seinen Enden und an wenigstens einer weiteren Stelle Kontaktbereiche eingeformt sind. Ein derartiger Draht kann auch einen komplexen dreidimensionalen Leitungsweg mit beliebig vielen Kontaktbereichen abbilden. Das Ausgangsmaterial lässt sich kostengünstig vorhalten und bei Bedarf in beliebigen Längen-Abschnitten zuschneiden und mit der notwendigen Anzahl von Kontaktbereichen versehen. Die Kontaktbereiche können auch zur Verbindung mit weiteren benachbarten dreidimensional gebogenen Drähten dienen, sodass insgesamt sehr komplex geformte Vorrichtungen zum Verbinden von elektrischen Bauteilen gebildet werden können.

Gemäß der Erfindung ist vorgesehen, dass der Draht einen runden Querschnitt aufweist. Dieser Querschnitt ermöglicht eine optimale dreidimensionale Verformbarkeit in beliebige Richtungen und Ebenen.

Gemäß einer weiteren vorteilhaften Ausgestaltung der Erfindung ist vorgesehen, dass die Kontaktbereiche als flache Prägungen in den Draht eingeformt sind.

Vorteilhaft weist zumindest einer der Kontaktbereiche wenigstens eine Bohrung oder Vertiefung auf, durch welche ein Befestigungsmittel zur Kontaktierung mit der Stromzufuhr oder dem elektrischen Bauteil oder zur Verbindung mit einem benachbarten dreidimensional gebogenen Draht hindurchführbar oder in welche ein Befestigungsmittel zur Kontaktierung mit der Stromzufuhr oder dem elektrischen Bauteil oder zur Verbindung mit einem benachbarten dreidimensional gebogenen Draht einpressbar oder einschraubbar ist.

Eine weitere vorteilhafte Weiterbildung der Erfindung sieht vor, dass in wenigstens eine der Bohrungen oder Vertiefungen ein Niet, ein Einpressdorn, ein Einpressteil oder eine Hülse einpressbar oder wenigstens eine Schraube einschraubbar ist. Hierdurch wird der Kontaktbereich vergrößert, der Kontakt zum Bauteil, zur Stromversorgung oder zu einem benachbarten dreidimensional gebogenen Draht verbessert und eine dauerhaft stabile Kontaktierung gewährleistet.

Der zur Herstellung der Vorrichtung verwendete Draht besteht bevorzugt aus einem Metall oder einer Metall-Legierung mit hoher elektrischer Leitfähigkeit.

Die Kontaktbereiche werden bevorzugt durch Pressen, Drücken und/oder Stanzen, erforderlichenfalls unter Zuhilfenahme eines Formwerkzeugs, wie eines Gesenks oder einer Matrize, in den Draht eingeformt und der Draht wird bevorzugt mittels einer Biegevorrichtung in seine dreidimensionale Form gebracht. Es ist auch möglich, dem Draht zuerst die gewünschte dreidimensionale Form aufzuprägen und anschließend die Kontaktbereiche durch Einlegen der entsprechenden Teilbereiche des Drahtes in ein Presswerkzeug und/oder Stanzwerkzeug zu formen.

Mit der Herstellung eines Kontaktbereichs können vorzugsweise zu kontaktierende Leiter, benachbarte dreidimensional gebogene Drähte oder Verbinder von elektrischen Bauteilen zur Herstellung einer festen Verbindung gemeinsam mit dem Kontaktbereich gepresst, gedrückt, gestanzt, geschweißt, geclincht, getoxt, gecrimpt oder genietet werden.

Eine weitere vorteilhafte Ausgestaltung der Erfindung sieht vor, dass die Kontaktbereiche zumindest an einem Ende des Drahtes als Kontakt eines Steckers ausgebildet sind. Hierbei ist es besonders vorteilhaft, wenn die Kontakte mit einem Dichtelement versehen in eine Aufnahme des Steckers einführbar sind. Hierdurch ist auch eine Verwendung in Umgebungen und Anwendungsbereichen möglich, bei denen es auf eine hohe Dichtigkeit der elektrischen Kontaktierung gegen Spritzwasser oder gegen entlang der Leiter kriechende Feuchtigkeit ankommt.

Das als Kontakt ausgebildete Ende des Drahtes ist vorzugsweise mittels einer Arretierung an bzw. in einem Gehäuse des Steckers festlegbar. Die Arretierung kann als mechanische Rasteinrichtung ausgebildet sein, wobei die Arretierungselemente bevorzugt zumindest teilweise am Gehäuse integral ausgebildet sind. Eine andere Variante besteht darin, die Arretierung durch eine zumindest teilweise Kunststoffumspritzung der Enden des Drahtes oder durch eine Kunststoffausspritzung eines Hohlraums im Gehäuse nach Einlegen der Enden des Drahtes erfolgen, wobei durch die Kunststoffumspritzung oder Kunststoffausspritzung neben der mechanischen Fixierung auch gleichzeitig eine hohe Dichtigkeit erzeugt wird.

Nachfolgend werden Ausführungsbeispiele der erfindungsgemäßen Vorrichtung unter Bezugnahme auf die Zeichnungen näher erläutert. Es zeigt:
- Fig. 1: einen Ausschnitt eines Gehäuses mit mehreren elektrischen Bauteilen, die durch erfindungsgemäße Vorrichtungen mit einer Stromversorgung verbunden sind;
- Fig. 2: die Vorrichtungen aus Fig. 1 in einer separaten dreidimensionalen Darstellung;
- Fig. 3: eine einzelne Vorrichtung aus Fig. 1 in einer separaten dreidimensionalen Darstellung;
- Fig. 4: herkömmliche Stromschienen (Stand der Technik)
- Fig. 5: eine einzelne Vorrichtung aus Fig. 1 in einer separaten dreidimensionalen Darstellung mit einer vertikal zur Haupterstreckungsrichtung angeordneten Schlaufe und Schraubverbindungen an den Enden;
- Fig. 6: eine einzelne Vorrichtung aus Fig. 1 in einer separaten dreidimensionalen Darstellung mit einer horizontal zur Haupterstreckungsrichtung angeordneten Schlaufe und Schraubverbindungen an den Enden;
- Fig. 7: ein Ende einer Vorrichtung mit einem als Kontaktbereich zu einem benachbarten Leiter ausgebildeten Schweißhaken:
- Fig. 8: ein Ende einer Vorrichtung mit einer als Kontaktbereich ausgebildeten Gabel;
- Fig. 9: ein Ende einer Vorrichtung mit einer als Kontaktbereich ausgebildeten Abflachung;
- Fig. 10: einen Kontaktbereich zur Verbindung zweier benachbarter Vorrichtungen mit in deren Kontaktbereich ausgebildeten ösenförmigen Abflachungen und einem das Auge der Ösen durchdringenden Niet als Befestigungsmittel;
- Fig. 11: einen Kontaktbereich zur Verbindung zweier benachbarter Vorrichtungen mit in deren Kontaktbereich nach Art einer Zunge und einer Gabel ausgebildeten Abflachungen vordem Zusammenfügen;
- Fig. 12: den Kontaktbereich gemäß Fig. 11 nach dem Zusammenfügen;
- Fig. 13: einen abgeflachten Kontaktbereich an einer Vorrichtung mit einer Bohrung und einem die durchdringenden Einpressdom;
- Fig. 14: einen Längsschnitt durch einen Kontaktbereich zweier benachbarter Vorrichtungen mit in deren Kontaktbereichen ausgebildeten Vertiefungen und Einpressteilen zur Herstellung einer Clinch- oder TOX®-Verbindung;
- Fig. 15: ein Ende einer Vorrichtung mit einem als Kontaktbereich zu einem benachbarten Leiter ausgebildeten Crimp-Anformung;
- Fig. 16: der Kontaktbereich gemäß Fig. 15 nach Herstellung der Crimp-Verbindung;
- Fig. 17: eine an einer Wand eines Bauteils ausgebildete Aufnahme für einen Kontaktbereich einer Vorrichtung im noch nicht verbundenen Zustand;
- Fig. 18: die Aufnahme und den Kontaktbereich im verbundenen Zustand;
- Fig. 19: eine perspektivische Ansicht auf eine Rückseite eines Steckers;
- Fig. 20: einen Längsschnitt durch den Stecker gemäß Fig. 19 im Bereich eines Drahtes;
- Fig. 21: einen Querschnitt durch den Stecker gemäß Fig. 19;
- Fig. 22: eine perspektivische Ansicht auf die Vorderseite des Steckers gemäß Fig. 19;
- Fig. 23: eine Variante eines Steckers mit einer am Gehäuse des Steckers angeformten Arretierung in geöffnetem Zustand;
- Fig. 24: den Stecker gemäß Fig. 23 bei geschlossenem Zustand der Arretierung;
- Fig. 25: eine perspektivische Ansicht einer weiteren Kontaktierungsvorrichtung mit einem für einpressbare Kontaktpins vorbereiteten Kontaktbereich; und
- Fig. 26: eine Seitenansicht der Ausführungsform gemäß Fig. 25.

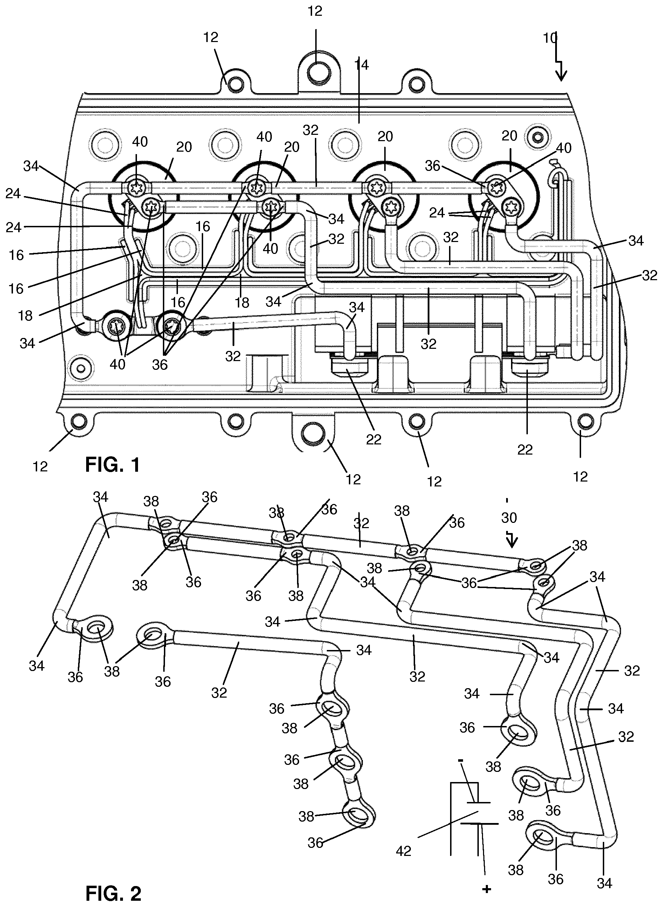

Ein in den Fig. 1 bis 3 dargestelltes Ausführungsbeispiel der Erfindung zeigt ein Gehäuse 10 eines mit mehreren elektrischen Bauteilen 20 bzw. 22 versehenen Aggregats. Das Gehäuse 10 ist im Randbereich mit mehreren Laschen 12 versehen, mittels derer das Gehäuse 10 beispielsweise im Motorraum eines Fahrzeugs an benachbarten Bauteilen befestigbar ist oder die zum Anbringen eines in Figur 1 nicht dargestellten Deckels zum Verschließen des Gehäuses 10 dienen.

Das Gehäuse 10 weist einen wannenförmigen Aufnahmeraum 14 auf, in dem parallel zueinander verlaufende Rippen 16 mehrere Führungskanäle 18 definieren, in denen zur Ansteuerung der elektrischen Bauteile 20 bzw. 22 dienende Signalleitungen 24 verlaufen.

Zur Verbindung der elektronischen Bauteile 20 bzw. 22 mit einer in Figur 2 dargestellten Stromversorgung 42 dient eine insgesamt mit 30 bezeichnete erfindungsgemäße Vorrichtung. Die Stromversorgung 42 weist einen Plus-Pol und einen Minus-Pol auf. Die Vorrichtung 30 setzt sich aus mehreren Drähten 32 zusammen, die bevorzugt einen runden Querschnitt aufweisen. Die Drähte 32 bestehen bevorzugt aus einem Metall oder einer Metall-Legierung mit einer hohen elektrischen Leitfähigkeit, wie beispielsweise Kupfer.

Die Drähte 32 weisen, wie in Figur 2 zu erkennen, an ihren Enden Kontaktbereiche 36 auf. Je nach Anzahl der zwischen den Enden der Drähte 32 zu kontaktierenden elektrischen Bauteile 20 bzw. 22 sind auch zwischen den Enden weitere Kontaktbereiche 36 vorgesehen, an denen auch weitere dreidimensional gebogenen Drähte 32 derselben elektrischen Polung zur Ergänzung der Vorrichtung verbunden sein können. Einige der Drähte 32 sind mit dem Plus-Pol der Stromversorgung 42 verbunden und dienen zur Stromversorgung der elektrischen Bauteile mit einem entsprechenden Leistungsstrom. Andere Drähte 32 sind mit dem Minus-Pol der Stromversorgung 42 verbunden und dienen der Rückleitung der Leistungsströme.

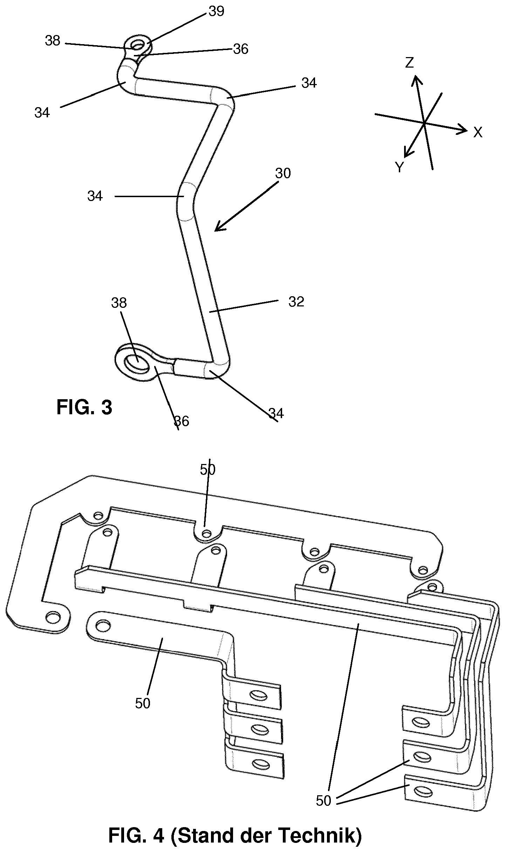

Die Drähte 32 werden mit mehreren Biegungen 34 in eine für die Kontaktierung wenigstens eines elektrischen Bauteils 20 bzw. 22, bevorzugt jedoch für die gleichzeitige Kontaktierung mehrerer elektrischer Bauteile 20 bzw. 22 untereinander und/oder mit der Stromversorgung 42 in eine dreidimensionale Form gebracht. Dabei folgen sie, wie in Figur 3 anhand eines einzelnen Drahtes 32 verdeutlicht, erforderlichenfalls auch mehrfach abwechselnd bevorzugt der X-Achse, der Y-Achse oder der Z-Achse des Gehäuses 10. Es sind jedoch auch andere Biegungen 34 abweichend von einem 90°-Winkel möglich.

Die Kontaktbereiche 36 sind aus dem Material der Drähte 32 heraus durch Prägen, Drücken, Stanzen, Walzen oder Pressen als flache, bevorzugt laschenförmige Bereiche geformt. Für das Anformen der Kontaktbereiche 36 an die Drähte 32 werden bevorzugt geeignete Formwerkzeuge, wie Gesenke, Prägestempel oder Prägezangen, Konturstanzwerkzeuge, Matrizen oder dergleichen verwendet. In die Kontaktbereiche 36 werden bevorzugt durch Stanzen oder Bohren Bohrungen 38 eingebracht, in welche, wie in Figur 3 im oberen Bereich angedeutet, auch Hülsen 39 eingepresst werden können. Die Bohrungen 38 bzw. die Hülsen 39 dienen zur Kontaktierung der Drähte 32 mit den elektrischen Bauteilen 20 bzw. 22. Hierzu werden bevorzugt durch die Bohrungen 38 bzw. durch die Hülsen 39 Befestigungsmittel 40 hindurchgeführt. In Figur 1 sind beispielhaft als Befestigungsmittel Torx-Schrauben 40 dargestellt.

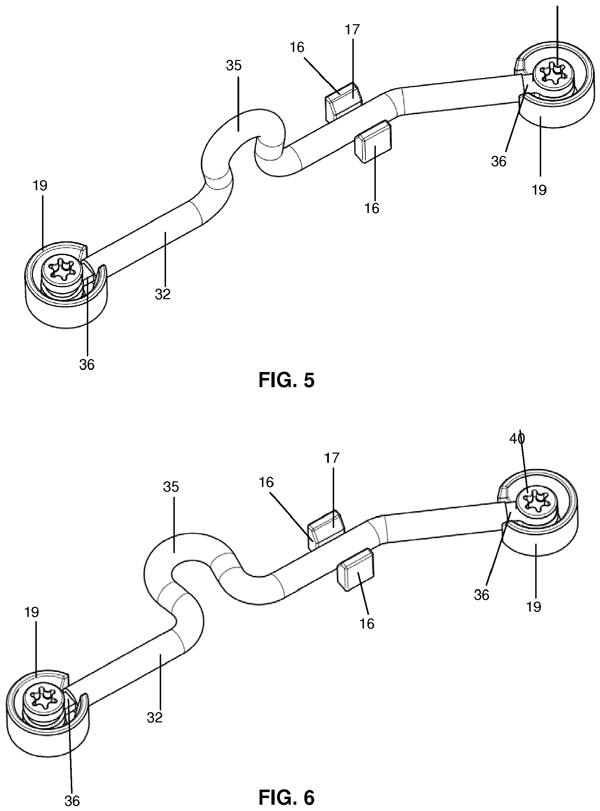

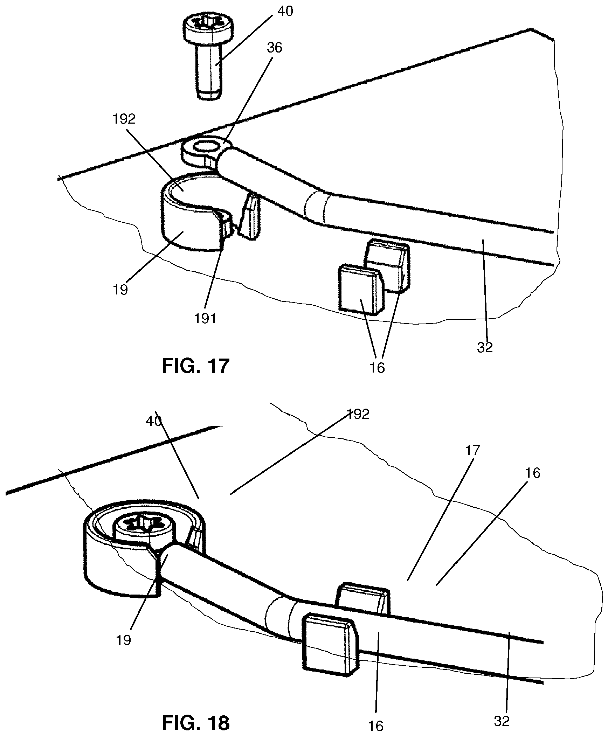

In den Figuren 5 und 6 ist ein dreidimensional gebogener Draht 32 gezeigt, in dessen beiden Endbereichen ösenförmige Kontaktbereiche 36 ausgebildet sind. Der Draht 32 weist außerdem eine sich in Figur 5 vertikal zur Haupterstreckungsrichtung des Drahtes 32 und in Figur 6 horizontal zur Haupterstreckungsrichtung des Drahtes 32 angeordnete Schlaufe 35 auf, die zur Kompensation der Länge des Drahtes 32 dient und vorzugsweise zur Korrektur der Länge des Drahtes 32 elastisch oder plastisch verformbar ist. Der Draht 32 wird zwischen an einer Wand des Gehäuses 10 oder an einer im Gehäuse 10 angeordneten Platine angeformten Rippen 16 geführt. Zum leichteren Hineindrücken des Drahtes 32 zwischen die Rippen 16 sind diese bevorzugt mit Einführschrägen 17 versehen. Die ösenförmigen Kontaktbereiche 36 an den Enden des Drahtes werden jeweils von einer an einer Wand des Gehäuses 10 oder an einer im Gehäuse 10 angeordneten Platine angeformten Aufnahme 19 aufgenommen. Diese weist, wie in den Figuren 17 und 18 dargestellt, bevorzugt ebenfalls eine Einführschräge 192 und im unteren Bereich einen Sockel 191 aus einem elektrisch isolierenden Material auf, sodass eine bezüglich der Wand des Gehäuses 10 oder einer Platine elektrisch isolierte Kontaktierung des Drahtes 32 erfolgen kann. Als Befestigungsmittel sind in den Figuren 5 und 6 und in den Figuren 17 und 18 Schrauben 40 vorgesehen, die entsprechenden Bohrungen in den Kontaktbereichen 36 durchdringen und mit einem Gewinde in eine Gewindebohrung in der Wand des Gehäuses 10 oder in der Platine eingeschraubt werden.

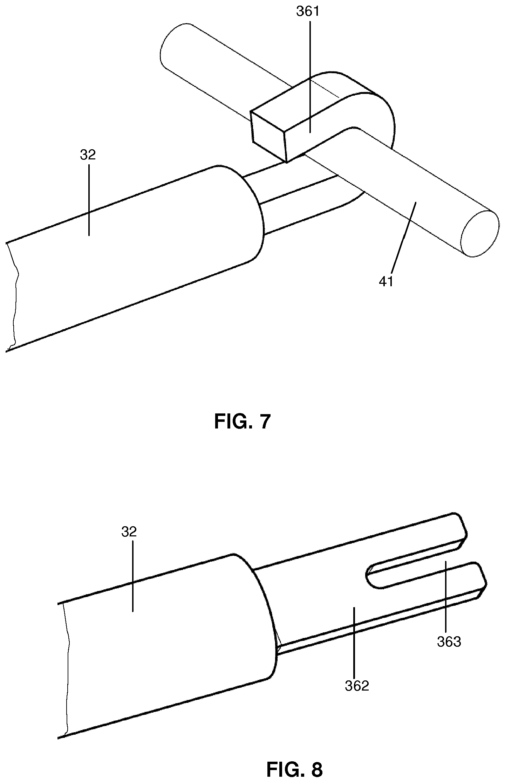

In Figur 7 ist ein Ende eines Drahtes 32 mit einem daraus geformten Schweißhaken 361 versehen, in dessen U-förmige Aufnahme ein Leiter 41 eingelegt und anschließend mit dem Schweißhaken 361 verschweißt wird.

In Figur 8 ist ein Kontaktbereich am Ende eines Drahtes 32 als Gabel 362 mit einem darin ausgebildeten Schlitz 363 geformt. Die Gabel 362 dient mit ihrem Schlitz 363 als Schweißgabel. Der Schlitz dient zur Aufnahme eines stiftförmigen Gegenkontakts, der mit der Gabel 362 verschweißt wird.

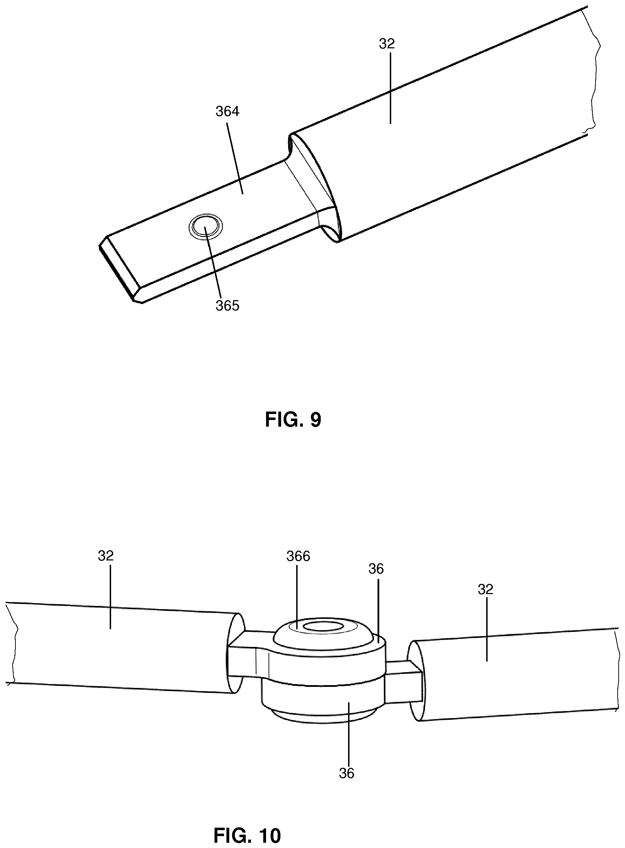

In Fig. 9 ist der Kontaktbereich als Abflachung 364 ausgebildet, der an einem Schweißpunkt 365 mit einem nicht dargestellten Gegenkontakt verschweißt wird.

In Fig. 10 ist eine Verbindung zweier Drähte 32 gezeigt, die an ihren Enden jeweils einen Kontaktbereich 36 in Form einer ösenförmigen Abflachung mit einem Durchgangsloch aufweisen. Die Kontaktbereiche 36 werden übereinanderliegend zur Deckung gebracht und mittels eines die Durchgangslöcher durchdringenden Niets 366 dauerhaft gelenkig oder optional auch fest mechanisch und elektrisch leitend miteinander verbunden.

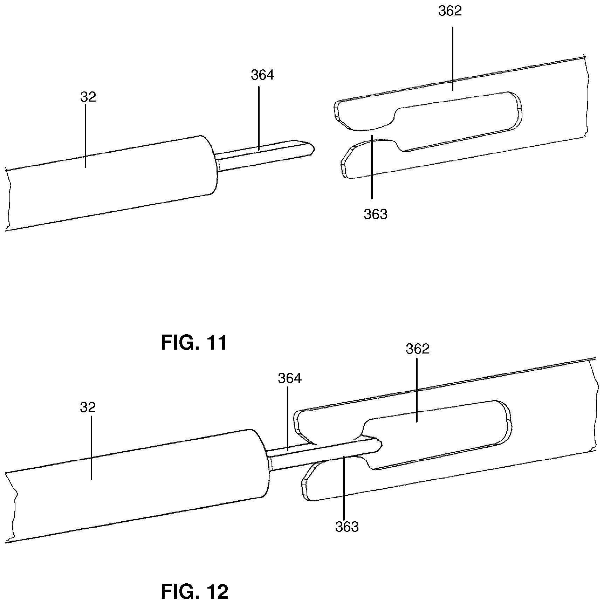

In Fig. 11 ist ein Ende eines Drahtes 32 als Abflachung 364 ausgebildet. Diese Abflachung 364 dient zum Zusammenfügen mit einem Schlitz 363 in einer Gabel 362, die an einem zu verbindenden Bauteil oder einem benachbarten Draht vorgesehen oder ausgebildet ist. In Fig. 12 ist der Kontakt durch Einschieben der an der Spitze mit Einführschrägen versehenen Abflachung 364 in den Schlitz 363 hergestellt. Dabei umgreift die Gabel 362 mit einer hinreichend starken Federkraft die Abflachung 364 und klemmt diese dauerhaft im Schlitz 363 fest. Optional kann eine zusätzliche Schweißverbindung zwischen Gabel 362 und Abflachung 364 vorgesehen sein.

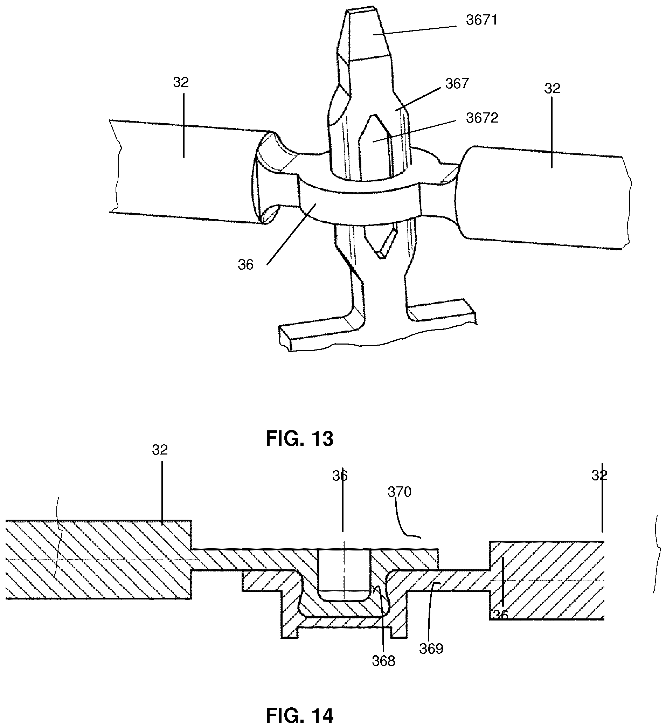

In Fig. 13 ist ein ösenförmig in einem Draht 32 ausgebildeter abgeflachter Verbindungsbereich 36 mit einer Bohrung versehen, die von einem Einpressdorn 367 als Gegenkontakt durchdrungen wird. Der Einpressdorn 367 weist an seiner nach oben weisen Spitze Einführschrägen 3671 auf und ist durch einen im Verbindungsbereich angeordneten Hohlraum 3672 elastisch verformbar, so dass er sich nach dem Einpressen mit einer starken Druckkraft an die Wand der Bohrung anlegt.

Wenn in dieser Anmeldung von "Bohrung" gesprochen wird, versteht der Fachmann darunter jegliche Form einer Aussparung, unabhängig von der Art der Herstellung, die beispielsweise auch durch Stanzen oder Durchdrücken erfolgen kann und unabhängig von der Form, die nicht notwendiger Weise rund sein muss.

In Fig. 14 sind zwei an benachbarten Enden zweier Drähte 32 angeordnete Verbindungsbereiche 36 als Abflachungen für das Anbringen einer Clinch- oder TOX®-Verbindung ausgebildet. Dabei wird die obere Abflachung mit einem Einpressteil 369 von einem Stempel, dessen Stempel-Vertiefung 370 nach dem Fügen sichtbar bleibt, formschlüssig unter Bildung eines Hinterschnitts im Randbereich in eine von einer Matrize abgestützte Vertiefung 368 der unteren Abflachung hineingedrückt.

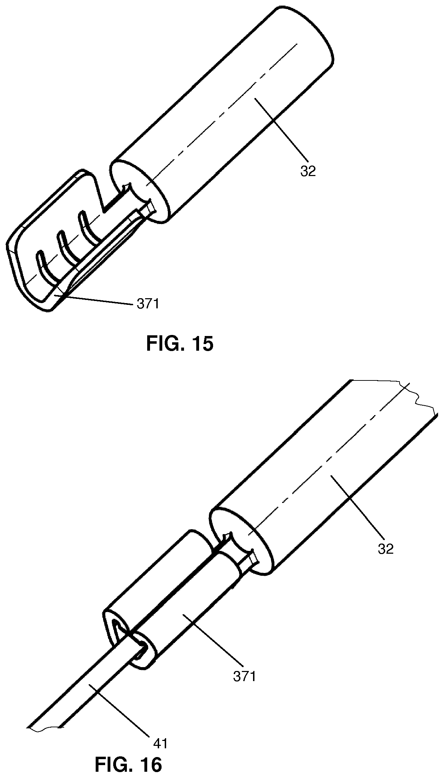

In Fig. 15 ist an einem Ende eines Drahts 32 eine Crimp-Anformung 371 ausgebildet, die nach Einlegen eines benachbarten Leiters 41 mittels eines Crimpwerkzeugs fest um diesen herumgedrückt wird (Fig. 16).

Die in den Figuren 17 und 18 dargestellte Aufnahme 19 wurde schon weiter vorne im Zusammenhang mit den Figuren 5 und 6 beschrieben.

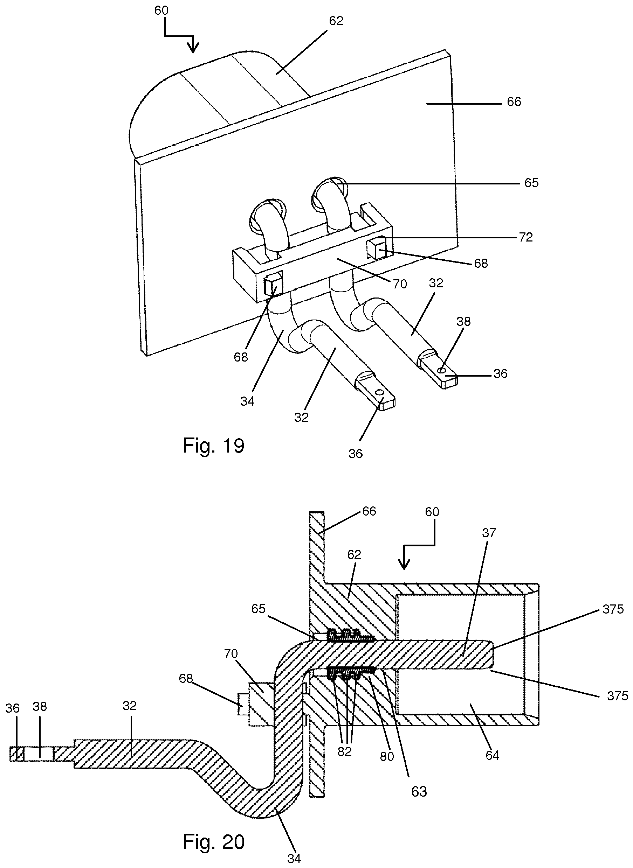

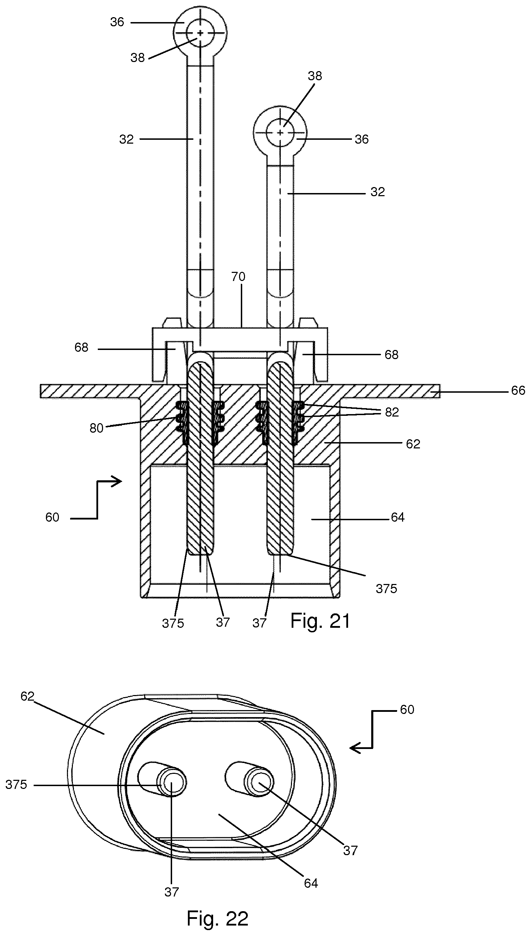

In den Figuren 19 bis 24 ist eine Variante der Erfindung dargestellt, bei der wenigstens ein Ende wenigstens eines Drahtes 32 als Kontakt 37 eines Steckers 60 ausgebildet ist. Der Stecker weist ein Gehäuse 62 auf, das auf seiner Vorderseite einen großen Hohlraum 64 nach Art einer Buchse bildet, in deren Mitte die beiden Kontakte 37 voneinander beabstandet angeordnet sind. Die Kontakte 37 weisen an ihrem einem nicht dargestellten komplementär geformten weiblichen Stecker zugewandten Ende eine Fase 375 auf, die das Zusammenfügen der Stecker erleichtert.

Das Gehäuse 62 weist an seiner Rückseite zwei kleinere zylindrische Aufnahmen 65 auf, in welche die die Kontakte 37 bildenden Enden der Drähte 32 mit einer jeweils aufgesteckten Dichtung 80 einsteckbar sind. Die Aufnahmen 65 sind über Durchgangsbohrungen 63 mit dem Hohlraum 64 verbunden, deren Durchmesser gegenüber den Aufnahmen 65 reduziert ist und im Wesentlichen dem Durchmesser der Drähte 32 entspricht. Die Dichtungen 80 umgeben mit einem in ihrem Inneren angeordneten Durchgang eng anliegend die Drähte 32 und legen sich mit mehreren an ihrem Außenumfang angeordneten umlaufenden Dichtlippen 82 eng an die Wandung der Aufnahmen 65 an.

An ihren auf der Rückseite des Gehäuses 62 herausgeführten Seiten sind die Drähte 32 um 90° nach unten abgebogen. In diesem vertikal verlaufenden Teil sind sie mittels einer Arretierung am Gehäuse 62 festgelegt. Die Arretierung wird im Ausführungsbeispiel gemäß den Figuren 19 bis 21 von einer Rastplatte 70 gebildet, die zwei Ausnehmungen 72 aufweist, durch welche jeweils ein stiftförmig von einer rückwärtigen Platte 66 des Gehäuses 62 vorstehendes Rastelement 68 hindurchgreift und mittels eines federnd bewegbaren Rasthakens die Rastplatte 70 unter Einklemmung der Drähte 32 gegen die Platte 66 des Gehäuses 62 drückt und an diesem fixiert.

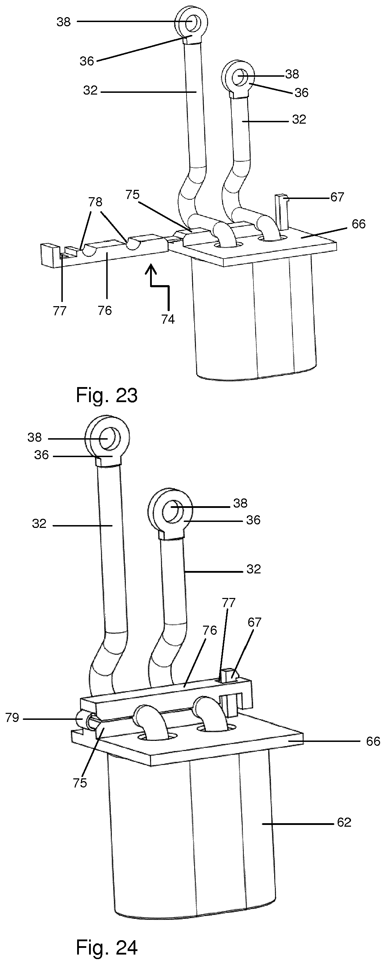

Beim Ausführungsbeispiel gemäß den Figuren 23 und 24 ist eine Rastplatte 74 unmittelbar am Gehäuse 62 angeformt. Dabei ist ein Unterteil 75 der Rastplatte 74 unmittelbar an der Rückseite der Platte 66 ausgebildet. Das Unterteil 75 weist zwei halbkreisförmige Nuten zur Aufnahme der Drähte 32 auf. Das Unterteil 75 ist an einem Ende mittels eines Filmscharniers 79 mit einem Oberteil verbunden, das ebenfalls zwei halbrunde Nuten 78 aufweist, die gemeinsam mit den Nuten am Unterteil die Drähte 32 nach Schließen der Rastplatte 74 dicht umschließen. Zum Schließen ist das Oberteil an seinem dem Filmscharnier 79 gegenüber liegenden Ende mit einer Ausnehmung 77 versehen, durch die ein stiftförmiges, an der Rückseite der Platte 66 angeordnetes Rastelement 67 mit einem federnd bewegbaren Widerhaken hindurchgreift und die beiden Teile 75 und 76 der Rastplatte 74 in geschlossener Position fest zusammenhält.

Die dem Stecker 60 abgewandten Rückseiten der Drähte 32 verlaufen anschließend an eine Biegung 34 wieder parallel zu den Kontakten 37. An ihren Enden sind sie über Kontaktbereiche 36 mit Bohrungen 38 mit benachbarten Drähten 32 oder mit elektrischen Bauteilen 20 bzw. 22 verbunden.

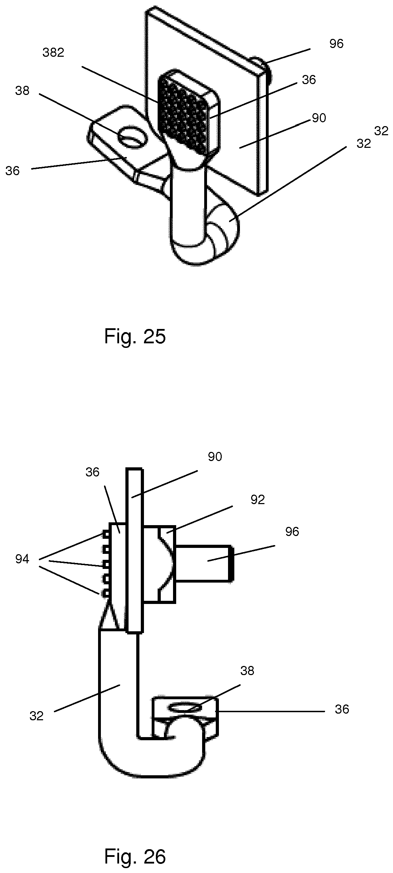

In den Figuren 25 und 26 ist ein weiteres Ausführungsbeispiel der Erfindung gezeigt, bei dem ein in die für eine Kontaktierung benötigte Form bereits vorgebogener, im Querschnitt runder Draht 32 an einem Ende mit einem der Figur 2 entsprechenden ösenförmig abgeflachten Kontaktbereich 36 mit einer darin angeordneten Bohrung 38 bevorzugt durch Umformung einstückig ausgebildet ist. Das andere Ende des Drahtes 32 ist mit einem im gezeigten Ausführungsbeispiel quadratisch oder rechteckig ausgebildeten, durch Umformung abgeflachten Kontaktbereich 36 versehen, in den eine Vielzahl von in einem regelmäßigen Lochraster angeordnete Bohrungen 382 eingeformt sind. Im gezeigten Ausführungsbeispiel sind dies fünfundzwanzig in einem gleichmäßigen, quadratischen Lochraster angeordnete Bohrungen 382. Es können jedoch ebenso auch andere Anordnungen mit quadratischen Lochrastern, beispielsweise mit neun, sechzehn oder sechsunddreißig Bohrungen 382 oder auch nicht quadratische, beispielsweise rechteckige, sechseckige oder achteckige Lochraster verwendet werden.

Die Bohrungen 382 dienen zum formschlüssigen Eingriff einer bevorzugt gleichen Zahl von Kontaktpins 94, die an einem Kontaktbauteil 92 angeordnet sind. Das Kontaktbauteil weist auf seiner in den Figuren 25 und 26 rechten Seite einen Kontaktdom 96 zur Anbindung eines benachbarten Bauteils oder eines elektrischen Leiters oder eines Verbindungselements auf. Die Kontaktpins 94 dienen im gezeigten Ausführungsbeispiel optional gleichzeitig zur Kontaktierung und Befestigung einer Platine 90, die zwischen dem Kontaktbauteil 92 und dem abgeflachten Kontaktbereich 36 angeordnet ist. Die Kontaktpins werden bevorzugt in die Bohrungen 382 eingepresst und bilden dadurch eine dauerhafte sichere Verbindung zwischen dem Kontaktbauteil 92 und dem abgeflachten Kontaktbereich 36 des Drahtes 32.

In Figur 4 sind zur Verdeutlichung des bisherigen Standes der Technik bislang verwendete, aus flachen Blechen gebildete Stromschienen 50 dargestellt, die durch Stanzen und Biegen in die gewünschte Form gebracht worden sind. Beim Stanzen derartiger Stromschienen entsteht relativ viel Verschnitt. Das Biegen in eine komplexe dreidimensionale Form ist für derartige Bleche nur begrenzt möglich.

Die Drähte 32 können bevorzugt nach dem Biegen in die gewünschte 3D-Kontur außerhalb der Kontaktbereiche 36, 361, 362, 363, 364, 365, 368, 370, 371, 37 mit einem isolierenden Überzug versehen werden. Dies kann beispielsweise durch Tauchen in einem Isolierlack unter Abdeckung der Kontaktbereiche 36, 361, 362, 363, 364, 365, 368, 370, 371, 37 erfolgen.

**Bezugszeichenliste**

| | | | |
|---|---|---|---|
| 10 | Gehäuse | 37 | Kontakt |
| 12 | Lasche | 375 | Phase |
| 14 | Aufnahmeraum | 38 | Bohrung |
| 16 | Rippe | 382 | Bohrungen (Lochraster) |
| 17 | Einführschräge | 39 | Hülse |
| 18 | Führungskanal | 40 | Befestigungsmittel (Schraube) |
| 19 | Aufnahme | 41 | Leiter |
| 191 | Sockel | 42 | Stromversorgung |
| 192 | Einführschräge | 50 | Stromschiene |
| 20 | (elektrisches) Bauteil | 60 | Stecker |
| 22 | (elektrisches) Bauteil | 62 | Gehäuse (von 60) |
| 24 | Signalleitung | 64 | Hohlraum (Buchse, an 62) |
| 30 | Vorrichtung | 65 | Aufnahme (an 62) |
| 32 | Draht | 66 | Platte (an 62) |
| 34 | Biegung | 67 | Rastelement (an 62) |
| 35 | Schlaufe | 68 | Rastelement (an 62) |
| 36 | Kontaktbereich | 70 | Rastplatte |
| 361 | Schweißhaken | 72 | Ausnehmung |
| 362 | Gabel | 74 | Rastplatte (an 62) |
| 363 | Schlitz | 75 | Unterteil (von 74) |
| 364 | Abflachung | 76 | Oberteil (von 74) |
| 365 | Schweißpunkt | 77 | Ausnehmung |
| 366 | Niet | 78 | Nut |
| 367 | Einpressdorn | 79 | Filmscharnier |
| 3671 | Einführschräge | 80 | Dichtelement |
| 3672 | Hohlraum | 82 | Dichtlippe |
| 368 | Vertiefung | 90 | Platine |
| 369 | Einpressteil (Clinch) | 92 | Kontaktbauteil |
| 370 | Stempel-Vertiefung | 94 | Kontaktpins |
| 371 | Crimp-Anformung | 96 | Kontaktdom |
| X | X-Achse | + | Plus-Pol |
| Y | Y-Achse | - | Minus-Pol |
| Z | Z-Achse | | |

## Patentansprüche

1. Vorrichtung (30) zum Verbinden von elektrischen Bauteilen (20, 22) mit einer Stromversorgung (42), wobei die Vorrichtung (30) von wenigstens einem dreidimensional gebogenen Draht (32) gebildet ist, der einen runden Querschnitt aufweist und in den zumindest an seinen Enden Kontaktbereiche (36) eingeformt sind, **dadurch gekennzeichnet, dass** an wenigstens einer weiteren, zwischen den Enden des Drahtes (32) liegenden Stelle zumindest ein weiterer Kontaktbereich (36) in den Draht (32) eingeformt ist.

2. Vorrichtung (30) nach Anspruch 1, **dadurch gekennzeichnet, dass** die Kontaktbereiche (36) als flach geprägte Bereiche des Drahtes (32) ausgebildet sind.

3. Vorrichtung (30) nach einem der Ansprüche 1 bis 2, **dadurch gekennzeichnet, dass** die Kontaktbereiche (36) als Verbindungsbereich zu einem benachbarten dreidimensional gebogenen Draht (32) ausgebildet sind.

4. Vorrichtung (30) nach einem der Ansprüche 1 bis 3, **dadurch gekennzeichnet, dass** in wenigstens einem der Kontaktbereiche (36) wenigstens eine Bohrung (38; 382) und/oder wenigstens eine Vertiefung (368, 370) und/oder wenigstens ein Schweißhaken (361) und/oder wenigstens eine Gabel (362) und/oder wenigstens eine Abflachung (364) und/oder wenigstens ein Schweißpunkt (365) und/oder wenigstens eine Crimp-Anformung (371) ausgebildet ist.

5. Vorrichtung (30) nach Anspruch 4, **dadurch gekennzeichnet, dass** die Bohrung (38; 382) oder Vertiefung (368, 370) zur Aufnahme wenigstens eines Befestigungsmittels (366, 367, 369, 40; 92) dient.

6. Vorrichtung (30) nach Anspruch 4 oder 5, **dadurch gekennzeichnet, dass** in die Bohrung (38; 382) oder Vertiefung (368, 370) wenigstens ein Niet (366) oder ein Einpressdorn (367) oder ein Einpressteil (369; 94) oder eine Hülse (39) einpressbar oder wenigstens eine Schraube (40) einschraubbar ist.

7. Vorrichtung (30) nach einem der Ansprüche 1 bis 6, **dadurch gekennzeichnet, dass** der Draht (32) aus einem Metall oder einer Metall-Legierung mit hoher elektrischer Leitfähigkeit besteht.

8. Vorrichtung (30) gemäß einem der vorhergehenden Ansprüche, **dadurch gekennzeichnet, dass** die Kontaktbereiche (36) durch Pressen, Drücken und/oder Stanzen in den Draht (32) geformt werden und der Draht (32) mittels einer Biegevorrichtung in seine dreidimensionale Form gebracht wird.

9. Vorrichtung (30) gemäß einem der vorhergehenden Ansprüche, **dadurch gekennzeichnet, dass** in den wenigstens einen dreidimensional gebogenen Draht (32) wenigstens eine Schlaufe (35) eingeformt ist.

10. Vorrichtung (30) gemäß einem der vorhergehenden Ansprüche, **dadurch gekennzeichnet, dass** die Kontaktbereiche (36) zumindest an einem Ende des Drahtes (32) als Kontakt (37) eines Steckers (60) ausgebildet sind.

11. Vorrichtung (30) nach Anspruch 10, **dadurch gekennzeichnet, dass** die Kontakte (37) mit einem Dichtelement (80) versehen in eine Aufnahme (65) des Steckers (60) einführbar sind.

12. Vorrichtung (30) nach Anspruch 10 oder 11, **dadurch gekennzeichnet, dass** das als Kontakt (37) ausgebildete Ende des Drahtes (32) mittels einer Arretierung (67, 68; 70, 74) an einem Gehäuse (62) des Steckers (60) festlegbar ist.

13. Vorrichtung (30) nach Anspruch 12, **dadurch gekennzeichnet, dass** die Arretierung (67, 68; 70, 74) zumindest teilweise am Gehäuse (62) ausgebildet ist.

14. Vorrichtung (30) gemäß einem der vorhergehenden Ansprüche, **dadurch gekennzeichnet, dass** der wenigstens eine dreidimensional gebogene Draht (32) außerhalb der Kontaktbereiche (36, 361, 362, 363, 364, 365, 368, 370, 371, 37) mit einem isolierenden Überzug versehen ist.

15. Vorrichtung nach Anspruch 14, **dadurch gekennzeichnet, dass** der isolierende Überzug durch Tauchen in einem Isolierlack unter Abdeckung der Kontaktbereiche (36, 361, 362, 363, 364, 365, 368, 370, 371, 37) gebildet ist.

## Claims

1. Device (30) for connecting electrical components (20, 22) to a power supply (42), the device (30) being formed by at least one three-dimensionally bent wire (32) which has a round cross section and in which contact regions (36) are formed at least at the ends thereof, **characterized in that** at least one additional contact region (36) is formed in the wire (32) at least at one additional position which is located between the ends of the wire (32).

2. Device (30) according to claim 1, **characterized in that** the contact regions (36) are formed as stamped-flat regions of the wire (32).

3. Device (30) according to either claim 1 to claim 2, **characterized in that** the contact regions (36) are formed as a connecting region to an adjacent three-dimensionally bent wire (32).

4. Device (30) according to any of claims 1 to 3, **characterized in that** at least one bore (38; 382) and/or at least one depression (368, 370) and/or at least one welding hook (361) and/or at least one fork (362) and/or at least one flat portion (364) and/or at least one welding point (365) and/or at least one crimp (371) is formed in at least one of the contact regions (36).

5. Device (30) according to claim 4, **characterized in that** the bore (38; 382) or depression (368, 370) is used to receive at least one fastening means (366, 367, 369, 40; 92).

6. Device (30) according to either claim 4 or claim 5, **characterized in that** at least one rivet (366) or a press-in mandrel (367) or a press-in part (369; 94) or a sleeve (39) can be pressed into the bore (38; 382) or depression (368, 370), or at least one screw (40) can be screwed into said bore or depression.

7. Device (30) according to any of claims 1 to 6, **characterized in that** the wire (32) consists of a metal or a metal alloy having high electrical conductivity.

8. Device (30) according to any of the preceding claims, **characterized in that** the contact regions (36) are formed by pressing, compressing and/or punching in the wire (32) and the wire (32) is brought into its three-dimensional shape by means of a bending device.

9. Device (30) according to any of the preceding claims, **characterized in that** at least one loop (35) is formed in the at least one three-dimensionally bent wire (32).

10. Device (30) according to any of the preceding claims, **characterized in that** the contact regions (36) are formed as a contact (37) of a plug (60) at least at one end of the wire (32).

11. Device (30) according to claim 10, **characterized in that** the contacts (37) which are provided with a sealing element (80) can be inserted into a receptacle (65) of the plug (60).

12. Device (30) according to either claim 10 or claim 11, **characterized in that** the end of the wire (32) which is formed as a contact (37) can be fixed to a housing (62) of the plug (60) by means of a detent (67, 68; 70, 74).

13. Device (30) according to claim 12, **characterized in that** the detent (67, 68; 70, 74) is formed at least in part on the housing (62).

14. Device (30) according to any of the preceding claims, **characterized in that** the at least one three-dimensionally bent wire (32) is provided with an insulating coating outside the contact regions (36, 361, 362, 363, 364, 365, 368, 370, 371, 37).

15. Device according to claim 14, **characterized in that** the insulating coating is formed by dipping in an insulating varnish, thus covering the contact regions (36, 361, 362, 363, 364, 365, 368, 370, 371, 37).

## Revendications

1. Dispositif (30) destiné à relier des composants électriques (20, 22) à une alimentation électrique (42), le dispositif (30) étant constitué d'au moins un fil (32) plié en trois dimensions présentant une section transversale ronde comportant des zones de contact (36) formées au moins à ses extrémités, **caractérisé en ce que**, au moins au niveau d'un autre point se trouvant entre les extrémités du fil (32), au moins une autre zone de contact (36) est formée dans le fil (32).

2. Dispositif (30) selon la revendication 1, **caractérisé en ce que** les zones de contact (36) sont réalisées sous la forme de zones plates estampées du fil (32).

3. Dispositif (30) selon l'une des revendications 1 à 2, **caractérisé en ce que** les zones de contact (36) sont réalisées sous la forme d'une zone de liaison à un fil (32) adjacent plié en trois dimensions.

4. Dispositif (30) selon l'une des revendications 1 à 3, **caractérisé en ce que**, dans au moins l'une des zones de contact (36), au moins un alésage (38 ; 382) et/ou au moins un évidement (368, 370) et/ou au moins un crochet de soudage (361) et/ou au moins une fourche (362) et/ou au moins un méplat (364) et/ou au moins un point de soudage (365) et/ou au moins une conformation de sertissage (371) est réalisé(e).

5. Dispositif (30) selon la revendication 4, **caractérisé en ce que** l'alésage (38 ; 382) ou l'évidement (368, 370) sert à recevoir au moins un moyen de fixation (366, 367, 369, 40 ; 92).

6. Dispositif (30) selon la revendication 4 ou 5, **caractérisé en ce que**, dans l'alésage (38 ; 382) ou dans l'évidement (368, 370), au moins un rivet (366) ou un mandrin d'insertion (367) ou une pièce d'insertion (369 ; 94) ou un manchon (39) peut être enfoncé(e) ou au moins une vis (40) peut être vissée.

7. Dispositif (30) selon l'une des revendications 1 à 6, **caractérisé en ce que** le fil (32) est constitué d'un métal ou d'un alliage métallique présentant une conductivité électrique élevée.

8. Dispositif (30) selon l'une des revendications précédentes, **caractérisé en ce que** les zones de contact (36) sont formées par pressage, par poussée et/ou par poinçonnage dans le fil (32), et le fil (32) est amené dans sa forme tridimensionnelle au moyen d'un dispositif de cintrage.

9. Dispositif (30) selon l'une des revendications précédentes, **caractérisé en ce qu'**au moins une boucle (35) est formée dans l'au moins un fil (32) plié en trois dimensions.

10. Dispositif (30) selon l'une des revendications précédentes, **caractérisé en ce que** les zones de contact (36) sont réalisées au moins à une extrémité du fil (32) comme contact (37) d'un connecteur (60).

11. Dispositif (30) selon la revendication 10, **caractérisé en ce que** les contacts (37) dotés d'un élément d'étanchéité (80) peuvent être insérés dans un logement (65) du connecteur (60).

12. Dispositif (30) selon la revendication 10 ou 11, **caractérisé en ce que** l'extrémité du fil (32) réalisée comme contact (37) peut être fixée à un boîtier (62) du connecteur (60) au moyen d'un dispositif de verrouillage (67, 68 ; 70, 74).

13. Dispositif (30) selon la revendication 12, **caractérisé en ce que** le dispositif de verrouillage (67, 68 ; 70, 74) est réalisé au moins partiellement sur le boîtier (62).

14. Dispositif (30) selon l'une des revendications précédentes, **caractérisé en ce que** l'au moins un fil (32) plié en trois dimensions est doté d'un revêtement isolant à l'extérieur des zones de contact (36, 361, 362, 363, 364, 365, 368, 370, 371, 37).

15. Dispositif selon la revendication 14, **caractérisé en ce que** le revêtement isolant est formé par immersion dans une laque isolante recouvrant les zones de contact (36, 361, 362, 363, 364, 365, 368, 370, 371, 37).
